# EUROPÄISCHE PATENTANMELDUNG

(11) **EP 1 906 718 A2**
(43) Veröffentlichungstag der Anmeldung: **02.04.2008**
(21) Anmeldenummer: 07017356.2
(22) Anmeldetag: 05.09.2007
(51) Int. Cl.: H05K 3/32

(54) **Bauteilanordnung**

(30) Priorität: 28.09.2006 DE 102006046259
(71) Anmelder: Diehl AKO Stiftung & Co. KG, 88239 Wangen (DE)
(72) Erfinder: Potthof, Erwin, 90552 Röthenbach (DE); Wolf, Johann, 90768 Fürth (DE)
(74) Vertreter: Diehl Patentabteilung

(57) **Zusammenfassung**

Eine Bauteilanordnung enthält ein elektronisches Bauteil (10) mit einem elektrischen Anschlusspin (16); eine Leiterplatte (12) mit einer elektrischen Kontaktfläche (14), mit welcher der Anschlusspin (16) des Bauteils (10) in elektrisch leitendem Kontakt steht; und eine Befestigungsvorrichtung (18-24) zum Montieren des Bauteils (10) in einem vorbestimmten Abstand auf der Leiterplatte (12). Zum Ermöglichen einer lötfreien und dauerhaften Verbindung des Anschlusspins (16) mit der Kontaktfläche (14) ist die Bauteilanordnung dadurch gekennzeichnet, dass der Anschlusspin (16) aus einem federelastischen Material besteht; dass der Anschlusspin (16) wenigstens eine Krümmung (32, 74) aufweist, sodass im montierten Zustand des Bauteils (10) auf der Leiterplatte (12) ein Federabschnitt (34, 48, 60, 72) des Anschlusspins (16) in Richtung zur Leiterplatte (12) vorgespannt ist; und dass das Bauteil (10) an seiner der Leiterplatte (12) zugewandten Seite ein Führungselement (38) zum Abstützen eines Halteabschnitts (30, 48, 60, 72) des Anschlusspins (16) aufweist, sodass ein Kontaktabschnitt (32, 36) des Anschlusspins (16) gegen die Kontaktfläche (14) der Leiterplatte (12) gedrückt ist. Eine bevorzugte Anwendung wird zum Beispiel in der lötfreien Verbindung eines Displays mit einer Leiterplatte bei einer Herdschaltuhr gesehen.

## Beschreibung

Die vorliegende Erfindung betrifft eine Bauteilanordnung gemäß dem Oberbegriff des Anspruchs 1, und insbesondere eine solche Bauteilverbindung, die eine lötfreie Verbindung eines Bauteils mit einer Leiterplatte ermöglicht.

Bei herkömmlichen Bauteilanordnungen besteht zum Beispiel bei Herdschaltuhren das Problem, dass die Leiterplattenseite, auf welcher das Display zu bestücken ist, gleichzeitig die Lötseite ist. Deshalb sind entweder spezielle Einrichtungen erforderlich, um eine maschinelle Lötverbindung des Displays herzustellen, oder das Display wird manuell mit der Leiterplatte verlötet. Beide Montagevarianten sind relativ aufwändig. Im Fall der Maschinen- oder Roboterlösung sind bei der Entwicklung der Leiterplatte zudem die Gestaltungsfreiheit der Leiterplatte einschränkende Vorgaben einzuhalten, welche die nutzbare Bestückungsfläche der Leiterplatte verringern.

Die vorliegende Erfindung hat deshalb die Aufgabe, eine Bauteilanordnung vorzusehen, die sowohl eine einfache Montage des Bauteils auf der Leiterplatte als auch eine sichere elektrische Kontaktierung zwischen diesen beiden Komponenten im Betrieb der Bauteilanordnung gewährleistet.

Diese Aufgabe wird gelöst durch eine Bauteilanordnung mit den Merkmalen des Anspruchs 1. Vorteilhafte Ausgestaltungen und Weiterbildungen der Erfindung sind Gegenstand der abhängigen Ansprüche.

Die Bauteilanordnung enthält ein elektronisches Bauteil mit einem elektrischen Anschlusspin; eine Leiterplatte mit einer elektrischen Kontaktfläche, mit welcher der Anschlusspin des Bauteils in elektrisch leitendem Kontakt steht; und eine Befestigungsvorrichtung zum Montieren des Bauteils in einem vorbestimmten Abstand auf der Leiterplatte- Die Bauteilanordnung ist weiter dadurch gekennzeichnet, dass der Anschlusspin aus einem federelastischen Material besteht; dass der Anschlusspin wenigstens eine Krümmung aufweist, sodass im montierten Zustand des Bauteils auf der Leiterplatte ein Federabschnitt des Anschlusspins in Richtung zur Leiterplatte vorgespannt ist; und dass das Bauteil an seiner der Leiterplatte zugewandten Seite ein Führungselement zum Abstützen eines Halteabschnitts des Anschlusspins aufweist, sodass ein Kontaktabschnitt des Anschlusspins gegen die Kontaktfläche der Leiterplatte gedrückt ist.

Die Kombination aus dem vorbestimmten Abstandes zwischen Bauteil und Leiterplatte, der federelastischen Materialeigenschaft des Anschlusspins, der speziellen Formgebung des Anschlusspins und dem Führungselement zum Abstützen des Anschlusspins ermöglicht eine einfache, lötfreie Verbindung zwischen dem Bauteil und der Leiterplatte mit einem dauerhaften Druckkontakt zwischen Anschlusspin und Kontaktfläche. Es entsteht zudem ein logistischer Vorteil, da die Leiterplattenbaugruppe vorgefertigt und das vom Kunden geforderte Bauteil in der Endmontage eingesetzt werden kann, sodass Varianten am Ende der Wertschöpfungskette problemlos gebildet werden können.

In einer Ausgestaltung der Erfindung weist das Führungselement eine Ausnehmung zur Aufnahme des Halteabschnitts des Anschlusspins auf, sodass eine sichere Positionierung des Anschlusspins relativ zur Kontaktfläche der Leiterplatte gewährleistet ist.

In einer weiteren Ausgestaltung der Erfindung ist der Halteabschnitt des Anschlusspins zusätzlich an dem Führungselement fixiert, um Kräfte auf die innere Kontaktstelle zwischen Anschlusspin und Bauteil zu minimieren.

Das Führungselement kann ferner mit einer Verstärkungsrippe zur Verbesserung der Formstabilität der gesamten Anordnung versehen sein.

In einer noch weiteren Ausgestaltung der Erfindung ist der Kontaktabschnitt des Anschlusspins mit Klebstoff an der Kontaktfläche der Leiterplatte fixiert. Auf diese Weise wird die Sicherheit der elektrischen Kontaktierung zwischen Anschlusspin und Kontaktfläche weiter verbessert. Außerdem kann in diesem Fall auch ein Material mit weniger federelastischen Eigenschaften für den Anschlusspin eingesetzt werden.

Falls das Bauteil mehrere Anschlusspins aufweist, ist diesen jeweils ein Führungselement zugeordnet und das Bauteil ist vorzugsweise mit einem der Leiterplatte zugewandten Fortsatz versehen, an dem alle Führungselemente für die Anschlusspins angeformt sind.

Zum Einhalten des vorbestimmten Abstands zwischen Bauteil und Federplatte weist die Befestigungsvorrichtung an dem Bauteil vorgesehene Rasthaken, die in Durchbrechungen der Leiterplatte verhakt sind, und Distanzstifte, die in Ausnehmungen oder Durchbrechungen der Leiterplatte positioniert sind, oder alternativ am Bauteil vorgesehene Stifte, die in entsprechenden Durchbrechungen der Leiterplatte verstemmt, vernietet oder dergleichen fixiert sind, auf.

Das elektronische Bauteil ist beispielsweise ein Display einer Herdschaltuhr.

Obige sowie weitere Merkmale und Vorteile der Erfindung werden aus der nachfolgenden Beschreibung bevorzugter, nicht-einschränkender Ausführungsbeispiele unter Bezug auf die beiliegenden Zeichnungen besser verständlich. Darin zeigen:
- Fig. 1: eine schematische Seitenansicht des Aufbaus einer Bauteilanordnung gemäß einem ersten Ausführungsbeispiel;
- Fig. 2: einen vergrößerten Ausschnitt der Bauteilanordnung des ersten Ausführungsbeispiels von Fig. 1 mit einem eine Kontaktfläche der Leiterplatte kontaktierenden Anschlusspin gemäß Ansicht A von Fig. 1;
- Fig. 3: eine schematische Seitenansicht entsprechend Fig. 2, die eine Variante des ersten Ausführungsbeispiels zeigt;
- Fig. 4: einen vergrößerten Ausschnitt der Bauteilanordnung eines zweiten Ausführungsbeispiels analog der Darstellung von Fig. 2, wobei Fig. 4A den Zustand vor der Montage und Fig. 4B den Zustand nach der Montage des Bauteils auf der Leiterplatte zeigen;
- Fig. 5: einen vergrößerten Ausschnitt der Bauteilanordnung eines dritten Ausführungsbeispiels analog der Darstellung von Fig. 2;
- Fig. 6: eine schematische Seitenansicht der Bauteilanordnung des dritten Ausführungsbeispiels analog der Darstellung von Fig. 1;
- Fig. 7: einen vergrößerten Ausschnitt der Bauteilanordnung eines vierten Ausführungsbeispiels analog der Darstellung von Fig. 2, wobei Fig. 7A den Zustand vor der Montage und Fig. 7B den Zustand nach der Montage des Bauteils auf der Leiterplatte zeigen; und
- Fig. 8: einen vergrößerten Ausschnitt der Bauteilanordnung eines fünften Ausführungsbeispiels analog der Darstellung von Fig. 2.

### (Erstes Ausführungsbeispiel)

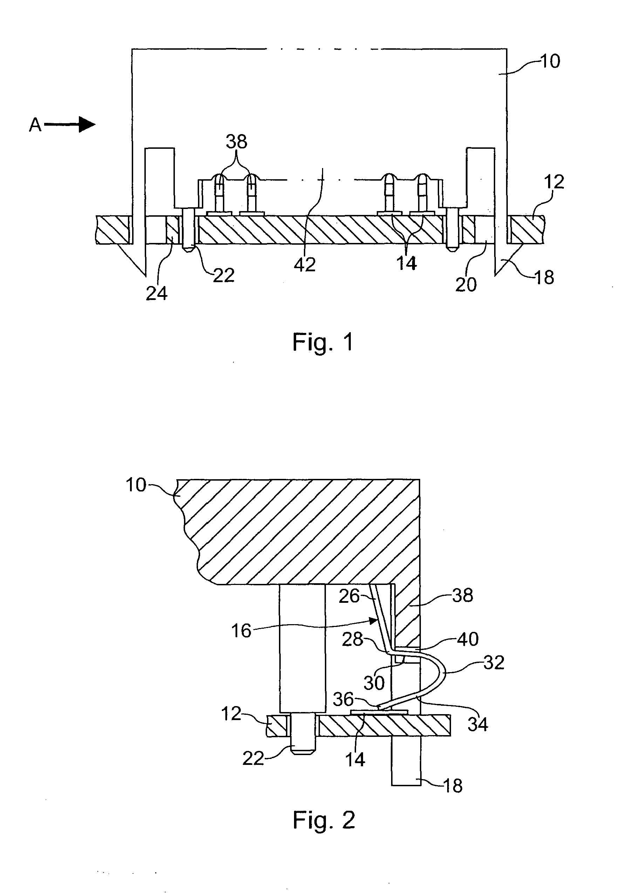

Anhand der Fig. 1 und 2 wird nun zunächst ein erstes Ausführungsbeispiel einer Bauteilanordnung näher erläutert. Dabei zeigt Fig. 1 die gesamte Bauteilanordnung in schematischer Seitenansicht, und Fig. 2 zeigt eine vergrößerte Detailansicht von Fig. 1 zur Erläuterung der elektrischen Verbindung zwischen Bauteil und Leiterplatte.

Die Bauteilanordnung umfasst im Wesentlichen ein elektronisches Bauteil 10, wie beispielsweise ein Display einer Herdschaltuhr, eine Leiterplatte 12 und eine Befestigungsvorrichtung 18-24 zum Montieren des Bauteils 10 in einem vorbestimmten Abstand auf der Leiterplatte 12. Die Leiterplatte 12 hat mehrere Kontaktflächen 14 zum elektrischen Anschließen des Bauteils 10, die auf der dem Bauteil 10 zugewandten Oberseite der Leiterplatte 12 angeordnet sind. Das elektronische Bauteil 10 besitzt mehrere elektrische Anschlusspins 16, die mit den jeweiligen Kontaktflächen 14 der Leiterplatte 12 in elektrisch leitenden Kontakt stehen müssen.

Die Befestigungsvorrichtung 18-24 weist mehrere Rasthaken 18 auf, die zum Beispiel jeweils in den Eckbereichen des Bauteils 10 an seinem Gehäuse in Richtung zur Leiterplatte 12 ragend angeformt und durch entsprechende Durchbrechungen 20 in der Leiterplatte 12 geführt sind, sodass sie an der Unterseite der Leiterplatte 12 verhaken, wie in Fig. 1 dargestellt. Anstelle dieser Rasthaken 18 können auch Stifte verwendet werden, die in entsprechenden Durchbrechungen der Leiterplatte 12 verstemmt, vernietet oder dergleichen fixiert werden. Im Fall der Verwendung von Rasthaken 18 weist das Bauteil 10 zusätzliche Distanzstifte 22 auf, die in Ausnehmungen oder Durchbrechungen 24 in der Leiterplatte 12 positioniert sind, um ein zu tiefes Eindrücken des Bauteils 10 zu verhindern.

Zum elektrischen Anschluss des Bauteils 10 an der Leiterplatte 12 müssen die elektrischen Anschlusspins 16 des Bauteils 10 die jeweiligen Kontaktflächen 14 der Leiterplatte 12 kontaktieren. Dies soll gemäß der Erfindung lötfrei erfolgen, um die eingangs genannten Nachteile bei herkömmlichen Bauteilanordnungen zu vermeiden. Es muss dabei gewährleistet werden, dass der erforderliche Kontaktdruck des Anschlusspins 16 gegen die Kontaktfläche 14 bei den jeweiligen Betriebsbedingungen, beispielsweise Umgebungstemperaturen von bis etwa 120°C bei Herdschaltuhren, aufrechterhalten bleibt.

Die elektrischen Anschlusspins 16 bestehen aus einem federelastischen Material, aufgrund der Temperaturanforderungen und Elastizitätsanforderungen vorzugsweise Federbronze.

Wie in Fig. 2 veranschaulicht, ist der Anschlusspin 16 des Bauteils 10 so geformt, dass er einen ersten (im Wesentlichen senkrechten) Abschnitt 26 an seinem dem Bauteil 10 zugewandten Ende aufweist, an den sich über eine erste Krümmung 28 ein zweiter (im Wesentlichen waagrechter) Abschnitt 30 anschließt (Halteabschnitt der Erfindung). Im weiteren Verlauf ist der Anschlusspin 16 in einer zweiten Krümmung 32 nochmals gebogen, sodass ein dritter (schräger) Abschnitt 34 entsteht, der in Richtung zur Leiterplatte 12 elastisch vorgespannt ist (Federabschnitt der Erfindung). Mit dem dem Bauteil 10 abgewandten Endabschnitt 36 (Kontaktabschnitt der Erfindung) steht der Anschlusspin 16 mit der Kontaktfläche 14 der Leiterplatte 12 in Kontakt. Der durch die zweite Krümmung 32 gebildete Federabschnitt 34 bewirkt ein Drücken des Kontaktabschnitts 36 gegen die Kontaktfläche 14.

Um zu vermeiden, dass die Elastizität des Federabschnitts 32 den ersten und den zweiten Abschnitt 26, 30 des Anschlusspins 16 nach oben drückt und somit ein unzureichender Kontaktdruck zwischen dem Kontaktabschnitt 36 des Anschlusspins 16 und der Kontaktfläche 14 entsteht, ist das Bauteil 10 ferner mit einem Führungselement 38 versehen. Das Führungselement 38 ist in diesem Ausführungsbeispiel ein an dem Gehäuse des Bauteils 10 angeformter Führungsstift, der kürzer als der vorbestimmte Abstand zwischen Bauteil 10 und Leiterplatte 12 ausgebildet ist, oder die Gehäusewand.

An seinem dem Bauteil 10 abgewandten Ende weist der Führungsstift 38 einen (im Wesentlichen waagrechten) Schlitz 40 oder dergleichen Ausnehmung auf. In diesen Schlitz 40 des Führungsstifts 38 ist der Halteabschnitt 30 des Anschlusspins 16 eingesetzt, sodass der Halteabschnitt 30 des Anschlusspins 16 abgestützt wird. Gleichzeitig werden hierdurch auch die Belastungskräfte des Anschlusspins 16 auf die innere Kontaktstelle des Bauteils 10 minimiert. Ferner wird die zweite Krümmung 32 des Anschlusspins 16 vorzugsweise als wenigstens eine Biegeschlaufe ausgeführt (Rückbiegung), weil bei dieser Ausführung die Gegenkraft zur Kontaktkraft in optimaler Weise auf das Führungselement 38 geleitet wird.

Es ist nun auch offensichtlich, dass das Bauteil 10 in einem vorbestimmten Abstand zur Leiterplatte 12 montiert werden muss (z.B. mittels Rasthaken 18 und Distanzstiften 22), damit bei der Montage des Bauteils 10 der federelastische Bereich des Anschlusspins 16 nicht so weit überschritten wird, dass der Anschlusspin keinen ausreichenden Kontaktdruck auf die Kontaktfläche 14 der Leiterplatte 12 aufbringen kann.

Üblicherweise ist das Bauteil 10 mit einer Anzahl von Anschlusspins 16 versehen, die mit einer entsprechenden Anzahl von Kontaktflächen 14 auf der Leiterplatte 12 in Kontakt gebracht werden müssen. Die Anschlusspins 16 sind alle zueinander gleich ausgebildet, und jedem Anschlusspin 16 ist ein entsprechendes Führungselement 38 zugeordnet. In einer vorteilhaften Ausgestaltung der Erfindung, wie sie in Fig. 1 dargestellt ist, weist das Gehäuse des Bauteils 10 einen gemeinsamen Fortsatz 42 auf, an dem alle Führungselemente 38 und gegebenenfalls auch noch die Distanzstifte 22 angeformt sind.

### (Modifikation des ersten Ausführungsbeispiels)

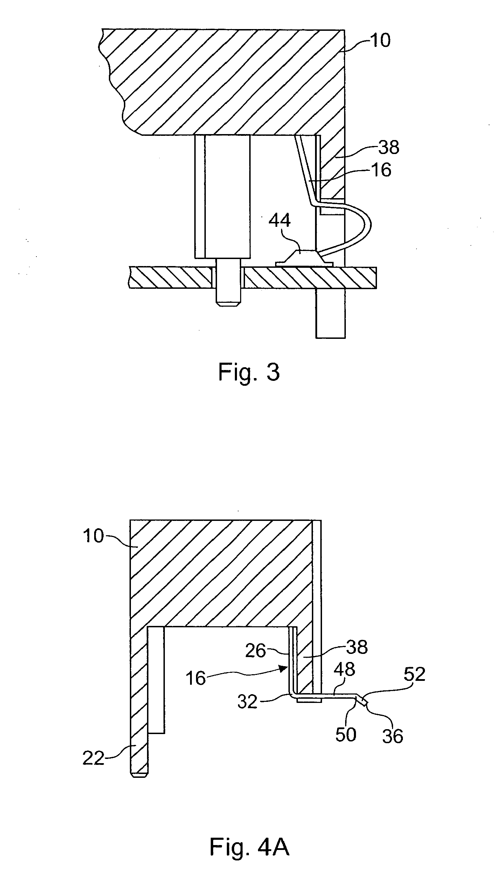

Unter Bezug auf Fig. 3 wird nun eine Variante des obigen ersten Ausführungsbeispiels beschrieben. Diese Variante ist in gleicher Weise auch auf die später erläuterten weiteren Ausführungsbeispiele anwendbar.

Um die Kontaktsicherheit zwischen dem Kontaktabschnitt 36 des Anschlusspins 16 und der Kontaktfläche 14 zu erhöhen, kann zusätzlich ein nicht-leitender Klebstoff 44 verwendet werden, der den Kontaktabschnitt 36 an der Kontaktfläche 14 fixiert. Beispielsweise kann ein Klebstoff 44 eingesetzt werden, wie er auch zum Kleben von SMD-Bauteilen verwendet wird. Beim Aufsetzen des Bauteils 10 auf die Leiterplatte 12 drücken die Anschlusspins 16 mit ihrem hohen spezifischen druck durch den Klebstoff 44 hindurch und erzeugen einen mechanischen und elektrischen Kontakt zur Kontaktfläche 14 der Leiterplatte 12. Nach dem Aushärten des Klebstoffes ist die Kontaktstelle gesichert.

Bei dieser Ausführungsform besteht außerdem die Möglichkeit, dass für die Anschlusspins 16 ein Standardmaterial mit nur geringen federelastischen Eigenschaften verwendet wird. Die elektrische Verbindung zur Leiterplatte 12 wird durch den Klebstoff 44 sichergestellt, und auf die inneren Kontaktstellen des Bauteils 10 werden so keine nennenswerten Kräfte ausgeübt.

### (Zweites Ausführungsbeispiel)

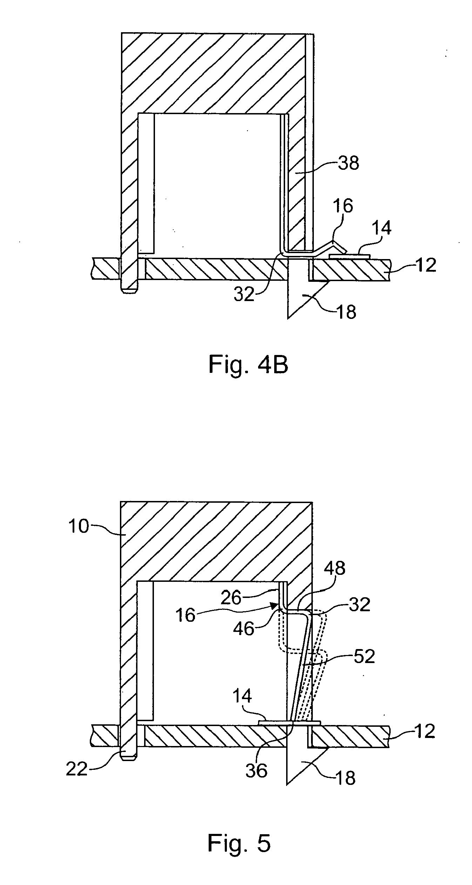

Es wird nun Bezug nehmend auf Fig. 4 ein zweites Ausführungsbeispiel der Bauteilanordnung erläutert. Dabei zeigt Fig. 4 eine vergrößerte Detailansicht analog Fig. 2 und gleiche oder entsprechende Komponenten sind mit den gleichen Bezugsziffern versehen wie im ersten Ausführungsbeispiel, sodass auf ihre detaillierte Beschreibung verzichtet werden kann. Weiter zeigt Fig. 4A einen Zustand des Bauteils und seines Anschlusspins vor der Montage auf einer Leiterplatte, und Fig. 4B zeigt einen Zustand des Bauteils und seines Anschlusspins nach der Montage, um die Wirkungsweise des Anschlusspins zu verdeutlichen.

In dem Ausführungsbeispiel von Fig. 4 ist der Anschlusspin 16 so geformt, dass er einen ersten (im Wesentlichen senkrechten) Abschnitt 26 an seinem dem Bauteil 10 zugewandten Ende aufweist, an den sich über eine erste Krümmung 32 ein zweiter (im Wesentlichen waagrechter) Abschnitt 48 anschließt (Halteabschnitt und Federabschnitt der Erfindung). Im weiteren Verlauf ist der Anschlusspin 16 in einer zweiten Krümmung 50 nochmals nach unten gebogen, sodass ein dritter Abschnitt 52 in Richtung zur Leiterplatte 12 entsteht. Der Endabschnitt 36 (Kontaktabschnitt der Erfindung) des dritten Abschnitts 52 steht mit der Kontaktfläche 14 der Leiterplatte 12 in Kontakt. Der durch die erste Krümmung 32 gebildete Federabschnitt 48 bewirkt im montierten Zustand des Bauteils 10 (Fig. 4B) ein Drücken des Kontaktabschnitts 36 gegen die Kontaktfläche 14.

Der senkrechte erste Abschnitt 26 des Anschlusspins 16 und das Führungselement 38 sind hier bevorzugt bis nahe zur Leiterplatte 12 ausgeführt. Es ist zudem vorteilhaft, den Halteabschnitt 48 an dem Führungselement 38 zu fixieren (z.B. mittels Verkleben, Verstemmen, Ultraschallschweißen), da bei der in Fig. 2 dargestellten Ausgestaltung des Anschlusspins 16 sonst eine Zugkraft in die innere Kontaktstelle des Bauteils 10 eingeleitet wird.

### (Drittes Ausführungsbeispiel)

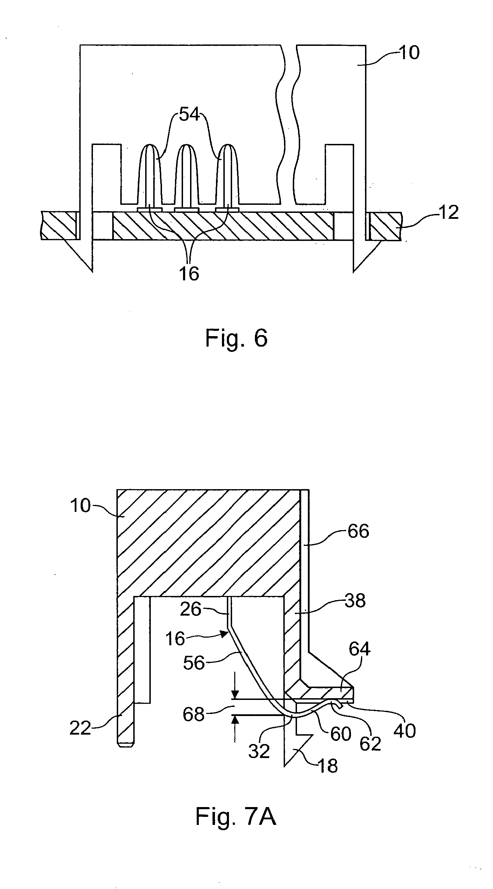

Ein drittes Ausführungsbeispiel einer Bauteilanordnung wird nun Bezug nehmend auf Fig. 5 und 6 erläutert. Dabei zeigt Fig. 5 eine vergrößerte Detailansicht analog Fig. 2 bzw. Fig. 6 eine schematische Seitenansicht analog Fig. 1, und gleiche oder entsprechende Komponenten sind mit den gleichen Bezugsziffern versehen wie in den ersten und zweiten Ausführungsbeispielen, sodass auf ihre detaillierte Beschreibung verzichtet werden kann.

Das dritte Ausführungsbeispiel unterscheidet sich von dem oben beschriebenen zweiten Ausführungsbeispiel darin, dass der dritte Abschnitt 52 des Anschlusspins 16 durch die entsprechenden Krümmungen 46 und 32 sehr steil zur Leiterplatte 12 angestellt ist, sodass sehr hohe Kontaktkräfte vom Kontaktabschnitt 36 auf die Kontaktfläche 14 entstehen. Der erste Abschnitt 26 des Anschlusspins 16 ist vorzugsweise relativ kurz ausgebildet, wie in Fig. 5 dargestellt. Der zweite Abschnitt 48 ist der Halteabschnitt, der sich am Gehäuse abstützt. In Fig. 5 sind in strichpunktierten Linien weitere Varianten angedeutet.

Aufgrund der sehr hohen Kontaktkräfte kann im vorliegenden Ausführungsbeispiel auch ein Standardmaterial für Anschlusspins mit nur geringen federelastischen Eigenschaften verwendet werden, sodass kaum Kräfte auf die innere Kontaktstelle des Bauteils eingeleitet werden. Der Überhub für den Kraftaufbau durch den Federabschnitt 52 muss so eingestellt werden, dass die sich aufbauende Kontaktkraft des Kontaktabschnitts 36 auf die Kontaktfläche 14 kleiner als die Knickkraft des steil angestellten Federabschnitts 52 ist.

Zur Stabilisierung der Form und der Positionierung des Anschlusspins 16 ist das Führungselement 38 bevorzugt ferner mit Ausnehmungen 54 in Form von Schlitzen oder Taschen zur seitlichen Führung des Anschlusspins 16 versehen.

### (Viertes Ausführungsbeispiel)

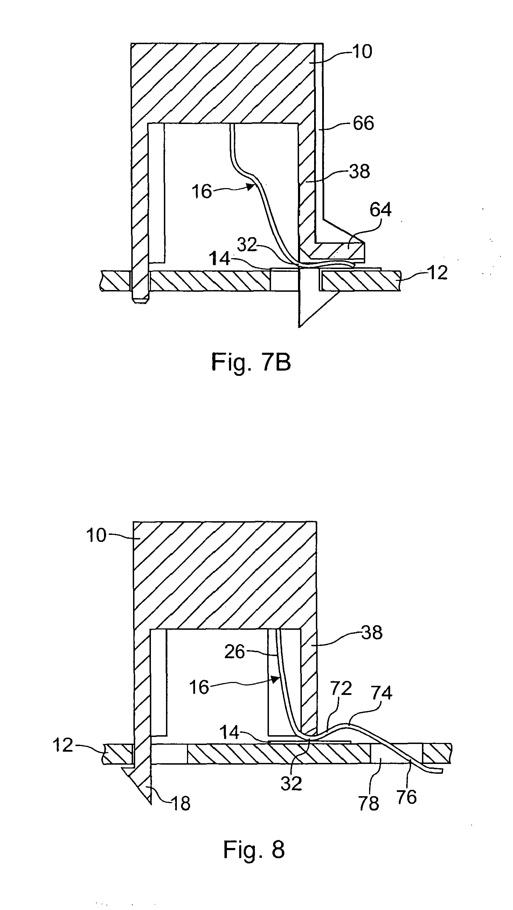

Ein viertes Ausführungsbeispiel einer Bauteilanordnung wird nun unter Bezug auf Fig. 7 erläutert. Dabei zeigt Fig. 7B (Montagezustand) eine vergrößerte Detailansicht analog Fig. 2, während Fig. 7A einen entsprechenden Vormontagezustand mit entspanntem Anschlusspin zeigt. Ferner sind gleiche oder entsprechende Komponenten mit den gleichen Bezugsziffern versehen wie im ersten Ausführungsbeispiel versehen, sodass auf ihre detaillierte Beschreibung verzichtet werden kann.

Im vorliegenden Ausführungsbeispiel ist der Anschlusspin 16 so geformt, dass er einen ersten (im Wesentlichen senkrechten) Abschnitt 26 an seinem dem Bauteil 10 zugewandten Ende aufweist, an den sich ein zweiter (gegenüber der Leiterplatte 12 leicht angestellter) Abschnitt 56 anschließt. Dann wird der Anschlusspin 16 über eine erste Krümmung 32 wieder nach oben gebogen und läuft in einem dritten Abschnitt 60, der hier als Halteabschnitt und als Federabschnitt der Erfindung dient, ein kurzes Stück nach oben, bevor der Anschlusspin 16 über eine zweite Krümmung 62 nochmals leicht nach unten gebogen wird.

Das Führungselement 38 erstreckt sich vom Bauteil 10 bis nahe zur Leiterplatte 12 und ist an seinem unteren Ende mit einem Fußabschnitt 64 versehen, der eine erweiterte Abstützfläche bzw. einen Druckstempel für den dritten Abschnitt 60 des Anschlusspins 16 bildet. Dieser Druckstempel 64 drückt den leicht federnden Bereich zwischen 32 und 62 des Anschlusspins 16 im montierten Zustand des Bauteils 10 (Fig. 7B) leicht nieder und erzeugt damit einen Druck der Krümmung 32 gegen eine Kontaktfläche 14 der Leiterplatte. Der zweite Abschnitt 56 wird dabei leicht elastisch verformt (siehe Fig. 7B).

Der Anschlusspin 16 erstreckt sich unterhalb des den Druckstempel bildenden Fußabschnitts 64 des Führungselements, wobei eine genauere Positionierung des Anschlusspins 16 durch eine Rille oder dergleichen Ausnehmung 40 in der der Leiterplatte 12 zugewandten Unterseite des Fußabschnitts 64 erreicht wird. In Fig. 7A ist zudem der Federweg 68 veranschaulicht, der im Montagezustand von Fig. 7 zur Kontaktpressung des Krümmungsabschnitts 32 gegen die Kontaktfläche 14 der Leiterplatte 12 zusammengedrückt wird.

Wie weiter in Fig. 7 veranschaulicht, kann das Führungselement 38 außerdem mit einer Verstärkungsrippe 66 versehen sein. Diese Modifikation ist in analoger Weise auch auf die übrigen Ausführungsbeispiele der Erfindung übertragbar.

### (Fünftes Ausführungsbeispiel)

Nachfolgend wird ein fünftes Ausführungsbeispiel einer Bauteilanordnung Bezug nehmend auf Fig. 8 erläutert, die in ihrer Darstellung der Detailansicht von Fig. 2 entspricht. Gleiche oder entsprechende Komponenten sind wieder mit den gleichen Bezugsziffern versehen wie im ersten Ausführungsbeispiel, sodass auf ihre nähere Beschreibung verzichtet werden kann.

Der Anschlusspin 16 ist so geformt, dass er einen ersten (im Wesentlichen senkrechten) Abschnitt 26 an seinem dem Bauteil 10 zugewandten Ende aufweist, der bis nahe zur Leiterplatte 12 reicht. Über eine erste Krümmung 32 geht der erste Abschnitt in einen leicht nach oben abgewinkelten zweiten Abschnitt 72 über, der hier sowohl als Halteabschnitt, der durch das Führungselement 38 abgestützt wird, als auch als Federabschnitt der Erfindung dient. Über eine zweite Krümmung 74 geht der Anschlusspin 16 dann in einen nach unten abgewinkelten dritten Abschnitt 76 (Klemmabschnitt der Erfindung) über. Dieser Klemmabschnitt 76 ragt durch eine Durchbrechung 78 in der Leiterplatte 12 ist an ihrer dem Bauteil 10 abgewandten Unterseite eingehakt.

Bei der Montage des Bauteils 10 wird zuerst der Klemmabschnitt 76 des Anschlusspins 16 in die Durchbrechung 78 der Leiterplatte 12 eingesetzt. Dann wird das Bauteil 10 nach unten geschwenkt, sodass das am Gehäuse des Bauteils 10 angeformte Führungselement 38 den Halteabschnitt 72 und den Krümmungsabschnitt 32 des Anschlusspins 16 nach unten drücken und schließlich die Rasthaken 18 des Bauteils 10 mit den Durchbrechungen 20 in der Leiterplatte 12 in Eingriff kommen. Die auch bei diesem Ausführungsbeispiel vorgesehenen Distanzstücke 22 des Bauteils 10 sind in Fig. 8 der besseren Übersichtlichkeit wegen nicht dargestellt. Dabei baut sich ein Kontaktdruck der Krümmung 32, die hier als Kontaktabschnitt des Anschlusspins 16 dient, auf und wird durch die eingeschnappten Rasthaken 18 aufrechterhalten.

### (Weitere Ausführungsbeispiele)

Während die vorliegende Erfindung anhand verschiedener Ausführungsbeispiele unter Bezug auf die beiliegenden Zeichnungen vollständig beschrieben worden ist, ist es selbstverständlich, dass zahlreiche Änderungen und Modifikationen durch den Fachmann daran vorgenommen werden können, ohne den in den anhängenden Ansprüchen definierten Schutzumfang zu verlassen.

Insbesondere die einzelnen Merkmale der oben beschriebenen Ausführungsbeispiele nahezu beliebig miteinander kombinierbar. Speziell die Fixierung der Kontaktstelle des Anschlusspins auf der Kontaktfläche der Leiterplatte mittels eines Klebstoffes sowie die Positionierung des Anschlusspins mittels einer geeigneten Ausnehmung am Führungselement sind bei allen Ausführungsbeispielen beliebig anwendbar.

Das Material der Anschlusspins muss lediglich ausreichende federelastische und warmfeste Eigenschaften aufweisen, ist aber im Übrigen nicht eingeschränkt.

### BEZUGSZIFFERNLISTE

- 10: elektronisches Bauteil
- 12: Leiterplatte
- 14: Kontaktfläche
- 16: Anschlusspin
- 18: Rasthaken
- 20: Durchbrechung
- 22: Distanzstift
- 24: Ausnehmung oder Durchbrechung
- 26: Abschnitt
- 28: Krümmung
- 30: Halteabschnitt
- 32: Krümmung, die in den Federbereich überleitet
- 34: Federabschnitt
- 36: Kontaktabschnitt
- 38: Führungselement
- 40: Schlitz
- 42: Fortsatz
- 44: Klebstoff
- 46: Krümmung
- 48: Halteabschnitt und Federabschnitt
- 50: Krümmung
- 52: Abschnitt und Federabschnitt
- 54: Ausnehmung
- 56: Abschnitt
- 60: Halteabschnitt und Federabschnitt
- 62: Krümmung
- 64: Fußabschnitt
- 66: Verstärkungsrippe
- 68: Federweg
- 72: Halteabschnitt und Federabschnitt
- 74: Krümmung
- 76: Klemmabschnitt
- 78: Durchbrechung

## Patentansprüche

1. Bauteilanordnung, mit
einem elektronischen Bauteil (10) mit einem elektrischen Anschlusspin (16); einer Leiterplatte (12) mit einer elektrischen Kontaktfläche (14), mit welcher der Anschlusspin (16) des Bauteils (10) in elektrisch leitendem Kontakt steht; und einer Befestigungsvorrichtung (18-24) zum Montieren des Bauteils (10) in einem vorbestimmten Abstand auf der Leiterplatte (12),
**dadurch gekennzeichnet,**
**dass** der Anschlusspin (16) aus einem federelastischen Material besteht;
**dass** der Anschlusspin (16) wenigstens eine Krümmung (32, 74) aufweist, sodass im montierten Zustand des Bauteils (10) auf der Leiterplatte (12) ein Federabschnitt (34, 48, 52, 60, 72) des Anschlusspins (16) in Richtung zur Leiterplatte (12) vorgespannt ist; und
**dass** das Bauteil (10) an seiner der Leiterplatte (12) zugewandten Seite ein Führungselement (38) zum Abstützen eines Halteabschnitts (30, 48, 60, 72) des Anschlusspins (16) aufweist, sodass ein Kontaktabschnitt (32, 36) des Anschlusspins (16) gegen die Kontaktfläche (14) der Leiterplatte (12) gedrückt ist.

2. Bauteilanordnung nach Anspruch 1,
**dadurch gekennzeichnet,**
**dass** das Führungselement (38) eine Ausnehmung (40) zur Aufnahme des Halteabschnitts (30, 48, 60, 72) des Anschlusspins (16) aufweist.

3. Bauteilanordnung nach Anspruch 1 oder 2,
**dadurch gekennzeichnet,**
**dass** die Krümmung (32) des Anschlusspins (16) als eine Rückbiegung ausgeführt ist.

4. Bauteilanordnung nach einem der Ansprüche 1 bis 3,
**dadurch gekennzeichnet,**
**dass** der Halteabschnitt (30, 48, 60, 72) des Anschlusspins (16) an dem Führungselement (38) fixiert ist.

5. Bauteilanordnung nach einem der Ansprüche 1 bis 4,
**dadurch gekennzeichnet,**
**dass** der Kontaktabschnitt (36) des Anschlusspins (16) steil auf die Kontaktfläche (14) der Leiterplatte (12) angestellt ist.

6. Bauteilanordnung nach einem der Ansprüche 1 bis 4,
**dadurch gekennzeichnet,**
**dass** das dem Bauteil (10) abgewandte Ende des Führungselements (38) einen Fußabschnitt (64) mit einer vergrößerten Abstützfläche aufweist.

7. Bauteilanordnung nach einem der Ansprüche 1 bis 6,
**dadurch gekennzeichnet,**
**dass** das Führungselement (38) mit einer Verstärkungsrippe (66) versehen ist.

8. Bauteilanordnung nach einem der Ansprüche 1 bis 7,
**dadurch gekennzeichnet,**
**dass** der Anschlusspin (16) an seinem dem Bauteil (10) abgewandten Ende ferner mit einem Klemmabschnitt (76) versehen ist, der durch eine Durchbrechung (78) in der Leiterplatte (12) geführt und der dem Bauteil (10) abgewandten Unterseite der Leiterplatte (12) eingehakt ist.

9. Bauteilanordnung nach einem der vorherigen Ansprüche,
**dadurch gekennzeichnet,**
**dass** der Kontaktabschnitt (32, 36) des Anschlusspins (16) mit Klebstoff (44) an der Kontaktfläche (14) der Leiterplatte (12) fixiert ist.

10. Bauteilanordnung nach einem der vorherigen Ansprüche,
**dadurch gekennzeichnet,**
**dass** das Bauteil (10) mehrere Anschlusspins (16) aufweist, denen jeweils ein Führungselement (38) zugeordnet ist; und
**dass** das Bauteil (10) mit einem der Leiterplatte (12) zugewandten Fortsatz (42) versehen ist, an dem alle Führungselemente (38) für die Anschlusspins (16) angeformt sind.

11. Bauteilanordnung nach einem der Ansprüche 1 bis 10,
**dadurch gekennzeichnet,**
**dass** die Befestigungsvorrichtung (18-24) an dem Bauteil (10) vorgesehene Rasthaken (18), die in Durchbrechungen (20) der Leiterplatte (12) verhakt sind, und Distanzstifte (22), die in Ausnehmungen oder Durchbrechungen (24) der Leiterplatte (12) positioniert sind, aufweist.

12. Bauteilanordnung nach einem der Ansprüche 1 bis 10,
**dadurch gekennzeichnet,**
**dass** die Befestigungsvorrichtung (18-24) an dem Bauteil (10) vorgesehene Stifte aufweist, die in entsprechenden Durchbrechungen der Leiterplatte (12) verstemmt, vernietet oder dergleichen fixiert sind.

13. Bauteilanordnung nach einem der vorherigen Ansprüche,
**dadurch gekennzeichnet,**
**dass** das elektronische Bauteil (10) ein Display ist.

14. Bauteilanordnung nach Anspruch 13,
**dadurch gekennzeichnet,**
**dass** die Bauteilanordnung Teil einer Hausgerätesteuerung oder einer Hausgeräteregeleinrichtung ist.
